# EUROPEAN PATENT SPECIFICATION

(11) **EP 0 487 468 B1**
(45) Date of publication and mention of the grant of the patent: **21.08.1996**
(21) Application number: 91830502.0
(22) Date of filing: 14.11.1991
(51) Int. Cl.: H01L 27/115, G11C 16/04, H01L 23/522, H01L 23/528

(54) **Flash-EPROM memory with single metal level, erasable per blocks of cells**
Blockslöschbare Flasch-EPROM-Speicheranordnung mit einer einzigen Metallschicht
Mémoire de type Flash-EPROM avec une unique couche métallique, effaçable par blocs de cellules

(30) Priority: 20.11.1990 IT 8365090
(43) Date of publication of application: 27.05.1992
(73) Proprietor: SGS-THOMSON MICROELECTRONICS S.r.l., I-20041 Agrate Brianza (Milano) (IT)
(72) Inventor: Natale, Virginia, I-20123 Milano (IT); Petrosino, Gianluca, I-22067 Missaglia (IT); Scarra' Flavio, I-20041 Agrate Brianza (IT)
(74) Representative: Pellegri, Alberto

(56) References cited:
- FR-A- 2 572 836

## Description

### FIELD OF THE INVENTION

The present invention relates to a FLASH-EPROM memory or more briefly a FLASH memory, having a single metal architecture and wherein selectable sectors of the memory array may be separately erased.

### BACKGROUND OF THE INVENTION

FLASH memories are rapidly finding numerous new fields of application. Their success is primarily due to the relatively small dimension of the unit cell, which is about equal to that of a traditional EPROM cell, coupled to the ability of being electrically erased. These characteristics ideally place FLASH memories between traditional EPROM memories (less expensive) and the EEPROM memories (much more expensive) from which they differ on one hand by being electrically erasable although the erasing can be carried out exclusively on the memory matrix as a whole, while an EEPROM memory may be erased byte by byte. On the other hand, a typical EEPROM unit cell is about four times larger than a FLASH cell.

This explains why the FLASH memories have conquered large sectors of the market where it is important to have nonvolatile, large-capacity memories which may be electrically erased eventually, but whose cost is relatively moderate.

One of the industrial sectors which is particularly interested to this type of memories is the automotive sector where on-board reprogramming of the memories is an indispensable requirement, e.g. for modifying the controlling parameters of a motor from time to time, or for recording the operating hystory of a motor between services, and the like.

In this as in other areas of utilization of FLASH memories, it would be highly desirable to be able to erase not the memory as a whole, but only a selectable portion or sector thereof. Such a possibility would be extremely useful. In the automotive area for example, manufacturers would find useful to install a FLASH memory wherein a system's managing program (ABS, control parameters of the motor, etc.) could be permanently stored, while on the other hand being able to modify the data stored by the program itself (e.g. timing and carburation parameters, temperature, etc., which have been acquired during the use of the vehicle and which must be erased after having been read by the computer of the maintenance workshop).

In a co-pending prior patent application of the same applicants, EP-A-0 486 444, a FLASH memory is described, wherein the erasing may be performed in a partialized manner on selectable portions of the memory matrix by fabricating the memory matrix with a two metal level architecture. The so-called diffused source lines constituting the source regions of the cells disposed on a same row of the memory matrix are not interconnected to form an electrically unique source node common to all the cells, as customary for these integrated devices. On the contrary, according to that invention, each source line is contacted through an individually selectable source connection line patterned in metal 2.

However, FLASH-EPROM memory devices normally have a single metal level architecture, and the addition of a second level metallization, while permitting erasability per blocks of cells of the memory matrix will increase the cost of production for these devices to some extent and may be unpracticable for other reasons, under particular circumstances.

### OBJECTIVE AND SUMMARY OF THE INVENTION

The main objective of the present invention is to provide a FLASH memory having a single metal level, wherein the erasing may be performed in a partialized manner on selectable portions of the memory matrix, without affecting other portions of the matrix.

This objective is fully met by means of the FLASH memory object of the present invention, whose architecture contemplates the interruption of purposely formed, (PRIMARY) source connection lines, which are patterned in a first level metal layer (metal 1), parallel to the BIT LINES, and to which isolated "lines" of diffused source regions of memory cells arranged on a same "row" of the matrix are connected through contacts which may be conveniently formed in the same manner the drain contacts with the respective BIT LINES are customarily formed, and the connection in common of respective segments of the interrupted source connection lines by means of two or more SECONDARY source interconnection lines which intersect a plurality of alignment segments and are also patterned in the same first level metal layer where the (PRIMARY) source connection lines and the same BIT LINES parallel to the latter are patterned. These SECONDARY source interconnection lines may be brought out of the matrix and individually connected to an external selection circuit for enabling the selection of a certain group of cells having their source regions connected to a certain SECONDARY line. Being said SECONDARY source interconnection lines patterned in the same first level metal layer orthogonally to the BIT LINES and to the segmented PRIMARY source connection lines, the BIT LINES are interrupted at crossings with the SECONDARY source interconnection lines and the electrical continuity of each BIT LINE is implemented by means of an "electrical underpath" which is realized by utilizing patterned portions of an existing underlying conducting layer. e.g. a polysilicon layer of a second level (poly 2), in which the control gate lines (WORD LINES) of the memory cells are patterned, as customary in the art.

An EPROM having such electrical underpaths is known from FR-A-2 572 836 for example.

In this way the FLASH EPROM memory of the invention may be erased by selectable blocks of cells while being fabricable through a single metal layer standard fabrication process.

The "electrical underpaths" made by means of "crosses" of polysilicon (poly 2) along each single BIT LINE of the matrix determine a certain increase of the electrical resistance of these lines and consequently an increase of the propagation delay of a logic signal along the same BIT LINES. However it has been observed that by limiting the number of interruptions of the source lines (columnwise) and therefore the number of electrical polysilicon by-passes for each BIT LINE, the increase of the propagation delay may be comfortably maintained within limits which are comtatible with an acceptable normal access time of the memory, which is established during the design of the memory device. For example, by employing four SECONDARY source interconnection lines in a memory matrix, which may be by-passed in pairs by utilizing two series of polysilicon crosses, i.e. two crosses of polysilicon along each BIT LINE, the memory matrix may be erased by four distinctly selectable blocks of cells, by biasing the cells of each selected block through a respective SECONDARY source interconnection line. The presence of two polysilicon crosses on each BIT LINE will not penalize in any remarkable manner the access time of the memory.

### BRIEF DESCRIPTION OF THE DRAWINGS

The different aspects and advantages of the invention will become more evident through the following description of an embodiment and reference to the attached drawings, wherein:
**Figure 1** is a simplified schematic plan view showing the organization of the source interconnections by groups or sectors of the memory cell matrix and of the relative electrical underpaths, formed in poly 2, along the BIT LINES of the matrix;
**Figure 2** is a simplified partial sectional view along the section line II-II of Fig. 1;
**Figure 3** is a simplified partial sectional view along section line III-III of Fig. 1.

### DESCRIPTION OF A PREFERRED EMBODIMENT

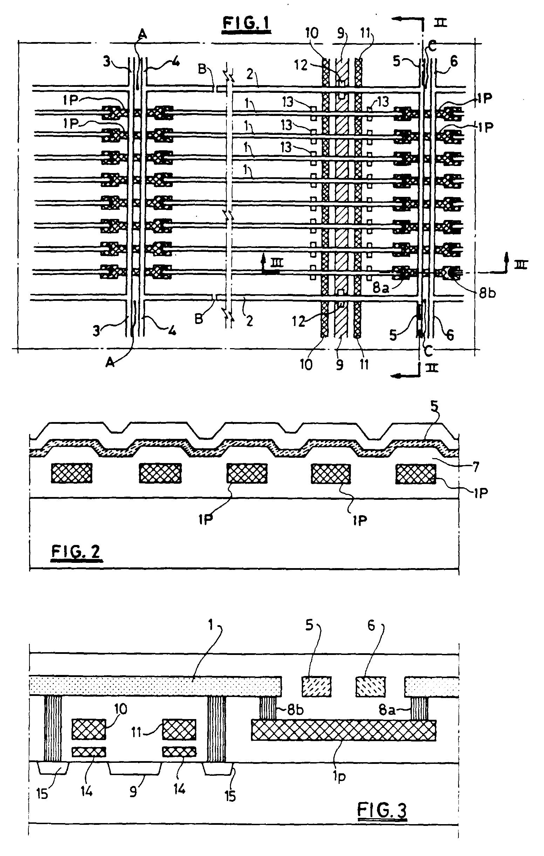

The schematic plan view of Fig. 1, shows an array of BIT LINES 1, of PRIMARY source connection lines 2 and of SECONDARY source interconnection lines 3, 4, 5 and 6, all patterned, in accordance with the instant invention, in a single metal layer (e.g. metal 1) which is normally present in these types of integrated devices.

The simplified plan view does not show all the other features of the memory cell matrix which are not strictly pertinent to a clear illustration of the subject matter of the present invention. It is assumed that any skilled technician will be perfectly capable of visualizing any other structural feature which has not been shown in the figures.

According to the present invention, each source connection line 2 is interrupted at point A, B and C. Each segment of PRIMARY source connection line may be electrically connected to the source regions (diffused source line) of a certain number of unit cells disposed along a same "row" of the matrix, through standard contacts which may be formed concurrently with the formation of the so-called drain contacts, which connects the drain region of each cell disposed along a same "column" of the matrix to a relative BIT LINE.

Keeping in mind that in the illustration of Fig. 1 the "rows" extend vertically while the "columns" extend horizontally, the pattern of one diffused source line 9, which constitutes a source region common to cells disposed along a row of the matrix is shown. As customary each diffused source line 9 is formed parallel to and between two adjacent control gate lines (WORD LINES) 10 and 11, which are part of the gate structure of the cells disposed along two adjacent rows of the matrix, respectively. The contacts 12 between the diffused source region 9 to aligned segments of PRIMARY source lines 2 may be formed concurrently with the drain contacts 13 which notably connect each single drain region belonging to a given cell to a respective BIT LINE 1 to which the drain regions of all cells disposed along a "column" of the matrix are connected. Of course the arrangement depicted is repeated a certain number of times between any two spaced apart SECONDARY source lines 4 and 5 and so forth. Indeed the partial illustration of Fig. 1 must be intended modularly expanded in both directions. Theoretically, to each segment of a source interconnection line 2, shown in the simplified partial view of Fig. 1, an unlimited number of unitary memory cells may have their relative diffused source regions connected, as will be easily recognized by the skilled person.

Each segment of each interrupted source connection line 2, is in turn connected in common with other segments of other interrupted source connection lines, aligned together, through an intersecting SECONDARY or auxiliary source interconnection line. These SECONDARY source interconnection lines are respectively indicated in Fig. 1 with 3, 4, 5 and 6, and are patterned in the same metal layer of first level. These SECONDARY source interconnection lines, 3, 4, 5 and 6, intersect orthogonally the respective series of segments of interrupted (PRIMARY) source connection lines 2. The SECONDARY source interconnection line runs orthogonally to the BIT LINES, through interruptions of the latter, and preferably are formed in pairs 3-4 and 5-6, for reducing the number of interruptions of the BIT LINES.

The continuity of each BIT LINE 1 in these crossing zones with a pair of SECONDARY source interconnection lines 3-4 and 5-6, is realized by forming an electrical underpath 1p in a polycrystalline silicon layer of a second level (poly 2). The second level polysilicon layer (poly 2) in which these by-passes are patterned in the same conducting layer in which the control gate lines (WORD LINES) (10 and 11 in Fig. 1) of the memory matrix are normally patterned, as will be easily recognized by the skilled technician.

These conducting by-passes 1p, made in poly 2, may be observed also in the partial sectional view of Fig. 2. The relative SECONDARY source interconnection line 5 is patterned in a metal layer which is deposited on a dielectric layer 7, which electrically isolates the patterned portions from the electrical by-passes 1p, patterned in poly 2. In the further sectional view of Fig. 3, the electrical connection between the electrical by-pass portion (1p) of polysilicon of second level (poly 2) and the respective truncated ends of an interrupted BIT LINE 1, patterned in the same first level metal layer, is shown. In the same metal layer a pair of distinct SECONDARY source interconnection lines 5 and 6, running orthogonally to the BIT LINES, are also patterned. The electrical connection is realized by forming two (high) contacts 8a and 8b, respectively, on the patterned portion 1p of second level polysilicon (poly 2). A cross section of two cells disposed on the same column and formed in adjacent rows is schematically visible in the cross section of Fig. 3. The respective channel regions between the common source diffusion 9 and the respective drain diffusions 15 are topped by the respective gate structures, each comprising a floating gate 14 topped by the control gate lines 10 and 11 (WORD LINES),respectively, which are patterned in the same polysilicon layer of second level (poly 2) as the electrical by-passes 1b.

As it may be easily observed in Fig. 1, the four SECONDARY source interconnection lines: 3, 4, 5 and 6, patterned in metal 1 while requiring only two interruptions of the patterned BIT LINES, permit a subdivision of the memory matrix, for the purpose of allowing an erasing per groups, in four groups or banks of cells, which may be individually selected by means of a dedicated selection circuitry, in order to permit the erasing of one or more of these four groups in any combination among each other, without affecting the cells of the nonselected groups.

## Claims

1. A FLASH-EPROM memory formed by a plurality of unit memory cells integrated in a semiconductor substrate, each cell having a drain region (15), a gate structure (10, 11, 14) and a source region (9), the cells being organized in a matrix of rows and columns and being individually addressable through a family of individually selectable parallel conducting word lines (10, 11) and a family of individually selectable parallel conducting bit lines (1) patterned in a first level metal layer disposed on an isolating dielectric layer (7), each word line of said family of word lines being part of said gate structure of the cells aligned along a certain row and each BIT LINE being connected through contacts (13) formed through said isolating dielectric layer to a drain region of the cells aligned along a certain column, the memory cells being erasable as a group by application of an erasing voltage to common source regions formed in said semiconducting substrate;
the memory comprising
a family of parallel, segmented, PRIMARY source connection lines (2), patterned in said first level metal layer , running parallel to and alternately with a plurality of said parallel bit lines ;
each segment of said segmented PRIMARY source connection lines being connected to a common source region of unit cells disposed along a certain row of the matrix by means of a contact (12) formed through said isolating dielectric layer;
a family of individually selectable parallel conducting SECONDARY source interconnection lines (3, 4, 5, 6), patterned in said first level metal layer, each orthogonally crossing and connecting in common a plurality of aligned segments of said PRIMARY source connection lines and orthogonally crossing said bit lines in interruption zones thereof;
the electrical continuity of each of said bit lines in the interruption zones being realized by means of an electrical underpath (1p) through a patterned portion of an existing conducting layer, in which said word lines (10, 11) are patterned;
the cells of said memory matrix being erasable in groups, having a common connected source region, through a selected SECONDARY source interconnection line.

2. The FLASH-EPROM memory according to claim 1, wherein said SECONDARY source interconnection lines are in a number multiple of two and are physically arranged in pairs of parallel lines, each pair of SECONDARY source interconnection lines crossing respective bit lines at single interruption zones of the latter.

## Patentansprüche

1. FLASH-EPROM-Speicher, der von mehreren Einheitsspeicherzellen gebildet ist, die auf einem Halbleitersubstrat integriert sind, wobei jede Zelle einen Drain-Bereich (15), eine Gate-Struktur (10, 11, 14) sowie einen Source-Bereich (9) besitzt, die Zellen in einer Matrix in Zeilen und Spalten organisiert ist und über eine Serie einzeln auswählbarer paralleler leitender Wortleitungen (10, 11) und über eine Serie einzeln auswählbarer paralleler leitender Bitleitungen (1), die in einer Metallschicht in einer ersten Ebene über einer Isolationsschicht (7) ausgebildet sind, einzeln adressierbar sind, wobei jede Wortleitung der Serie von Wortleitungen Teil der Gate-Struktur der längs einer bestimmten Zeile angeordneten Zellen ist und jede Bitleitung über Durchkontaktierungen (13), die durch die dielektrische Isolationsschicht ausgebildet sind, mit den Drain-Bereichen der längs einer bestimmten Spalte ausgerichteten Zellen verbunden ist, und wobei die Speicherzellen durch Anlegen einer Löschspannung an die gemeinsamen Source-Bereiche, die auf dem Halbleitersubstrat ausgebildet sind, als Gruppe gelöscht werden können; wobei der Speicher umfaßt:
eine Serie paralleler, segmentierter primärer Source-Verbindungsleitungen (2), die in der Metallschicht in der ersten Ebene ausgebildet sind und parallel zu und wechselweise mit mehreren der parallelen Bitleitungen verlaufen; wobei
jedes Segment der segmentierten primären Source-Verbindungsleitungen über eine Kontaktierung (12), die durch die dielektrische Isolationsschicht ausgebildet ist, mit einem gemeinsamen Source-Bereich der Einheitszellen verbunden ist, die längs einer bestimmten Zeile der Matrix angeordnet sind;
eine Serie einzeln auswählbarer paralleler leitender sekundärer Source-Zwischenverbindungsleitungen (3, 4, 5, 6), die in der Metallschicht in der ersten Ebene ausgebildet sind und jeweils gemeinsam mehrere ausgerichtete Segmente der primären Source-Zwischenverbindungsleitungen senkrecht kreuzen und mit diesen verbunden sind, während sie die Bitleitungen in ihren Unterbrechungszonen kreuzen;
wobei die elektrische Durchgängigkeit jeder Bitleitung in den Unterbrechungszonen mittels einer elektrischen Unterführung (1p), die im Musterabschnitt einer bestehenden Leiterschicht, in der die Wortleitungen (10, 11) ausgebildet sind, verwirklicht ist;
die Zellen der Speichermatrix über eine ausgewählte sekundäre Source-Zwischenverbindungsleitung in Gruppen mit einem gemeinsamen verbundenen Source-Bereich gelöscht werden kann.

2. FLASH-EPROM nach Anspruch 1, in dem die sekundären Source-Zwischenverbindungsleitungen in einem Vielfachen von Zwei und physisch in Paaren von parallelen Leitungen angeordnet sind, wobei jedes Paar von Source-Zwischenverbindungsleitungen entsprechende Bitleitungen in einzelnen Unterbrechungszonen derselben kreuzt.

## Revendications

1. Mémoire FLASH-EPROM constituée d'une pluralité de cellules mémoire élémentaires intégrées dans un substrat semiconducteur, chaque cellule ayant une région de drain (15), une structure de grille (10, 11, 14) et une région de source (9), les cellules étant organisées en une matrice de rangées et de colonnes, individuellement adressables par l'intermédiaire d'une famille de lignes de mots conductrices, parallèles, et sélectionnables individuellement (10, 11), et une famille de lignes de bits conductrices, parallèles et sélectionnables individuellement, gravées dans une couche de métal de premier niveau déposée sur une première couche de diélectrique isolant (7), chaque ligne de mots de la famille de lignes de mots faisant partie de la structure de grille des cellules alignées le long d'une rangée donnée et chaque ligne de bits étant connectée par l'intermédiaire de contacts (13) formés à travers la première couche de diélectrique isolant à une région de drain des cellules alignées le long d'une colonne donnée, les cellules mémoire étant effaçables par groupes par application d'une tension d'effacement à des régions de sources communes formées dans le substrat semiconducteur,
la mémoire comprenant :
une famille de lignes primaires (2) de connexion de sources, segmentées et parallèles, gravées dans la couche de métal de premier niveau, s'étendant parallèlement à et de façon alternée avec une pluralité des lignes de bits parallèles ;
chaque segment des lignes primaires de connexion de sources segmentées étant connecté à une région de source commune des cellules élémentaires disposées le long d'une certaine rangée de la matrice au moyen d'un contact (12) formé à travers la couche de diélectrique isolant ;
une famille de lignes secondaires (3, 4, 5, 6) d'interconnexion de sources conductrices, parallèles et individuellement sélectionnables, gravées dans la couche de métal de premier niveau, chacune croisant orthogonalement et connectant en commun une pluralité de segments alignés des lignes primaires de connexion de sources et croisant orthogonalement les lignes de bits dans des zones d'interruption de celles-ci ;
la continuité électrique de chacune des lignes de bits dans les zones d'interruption étant réalisée au moyen d'un sous-chemin électrique (1P) dans une partie gravée d'une couche conductrice existante dans laquelle les lignes de mots (10, 11) sont gravées ;
les cellules de la matrice mémoire étant effaçables par groupes, ayant une région de source connectée en commun, par l'intermédiaire d'une ligne secondaire sélectionnée d'interconnexion de sources.

2. Mémoire FLASH-EPROM selon la revendication 1, dans laquelle les lignes secondaires d'interconnexion de sources sont en un nombre multiple de deux et sont physiquement disposées par paire de lignes parallèles, chaque paire de lignes secondaires d'interconnexion de sources croisant les lignes de bits respectives au niveau de zones d'interruption uniques de ces dernières.
